# EUROPEAN PATENT APPLICATION

(11) **EP 2 720 261 A2**
(43) Date of publication of application: **16.04.2014**
(21) Application number: 13188032.0
(22) Date of filing: 10.10.2013
(51) Int. Cl.: H01L 23/34, H01L 23/427

(54) **Power converter and method for detecting freezing of refrigerant**

(30) Priority: 15.10.2012 JP 2012227591
(71) Applicant: Hitachi Ltd., Tokyo 100-8280 (JP)
(72) Inventor: Mori, Yuki, Chiyoda-ku Tokyo 100-8280 (JP); Sagawa, Akira, Chiyoda-ku Tokyo 100-8280 (JP); Yamanaka, Fumio, Chiyoda-ku Tokyo 100-8280 (JP); Okayasu, Takeshi, Chiyoda-ku Tokyo 100-8280 (JP); Terakado, Shuichi, Chiyoda-ku Tokyo 100-8280 (JP); Hishida, Akihiro, Chiyoda-ku Tokyo 100-8280 (JP); Yasuda, Yosuke, Chiyoda-cu Tokyo 100-8280 (JP)
(74) Representative: Gill, Stephen Charles

(57) **Abstract**

The present invention aims at providing a control to detect freezing of a refrigerant and to suppress the load applied on semiconductor devices for the power conversion at an early stage. Provided is a power converter comprising a plurality of semiconductor devices for the power conversion, a heat-receiving member, a plurality of heat pipes, a plurality of temperature sensors, and a plurality of heat radiating fins; wherein the semiconductor devices for the power conversion are disposed on one side of the heat-receiving member; the temperature sensors are attached to either the surface of the semiconductor devices for the power conversion or to a heat-receiving member surface that is the same as a mounting surface of the semiconductor devices for the power conversion; the plurality of heat pipes are attached to another surface of the heat-receiving member; at least a portion of the plurality of heat pipes has a heat radiating section; the plurality of fins are attached to the heat radiating section of the plurality of heat pipes; and freezing of a refrigerant filled in the plurality of heat pipes can be detected by monitoring a difference between a temperature measured via a portion of the plurality of temperature sensors and a temperature measured via a portion of the temperature sensors arranged at another location.

## Description

### BACKGROUND OF THE INVENTION

### Field of the invention

The present invention relates to power converters in general.

### Description of the related art

Power converters mounted on railway vehicles perform power conversion by converting power entered through overhead contact lines via switching of multiple semiconductor devices for the power conversion to carry out drive control of motors for vehicles, and the devices are disposed under the floor of the vehicles, for example. The power converters radiate heat generated by the switching operation of semiconductor devices for the power conversion as loss, so that a system for cooling the semiconductor devices for the power conversion using a heat pipe cooler is provided for realizing stable operation of devices, as shown in Patent Document 1,.

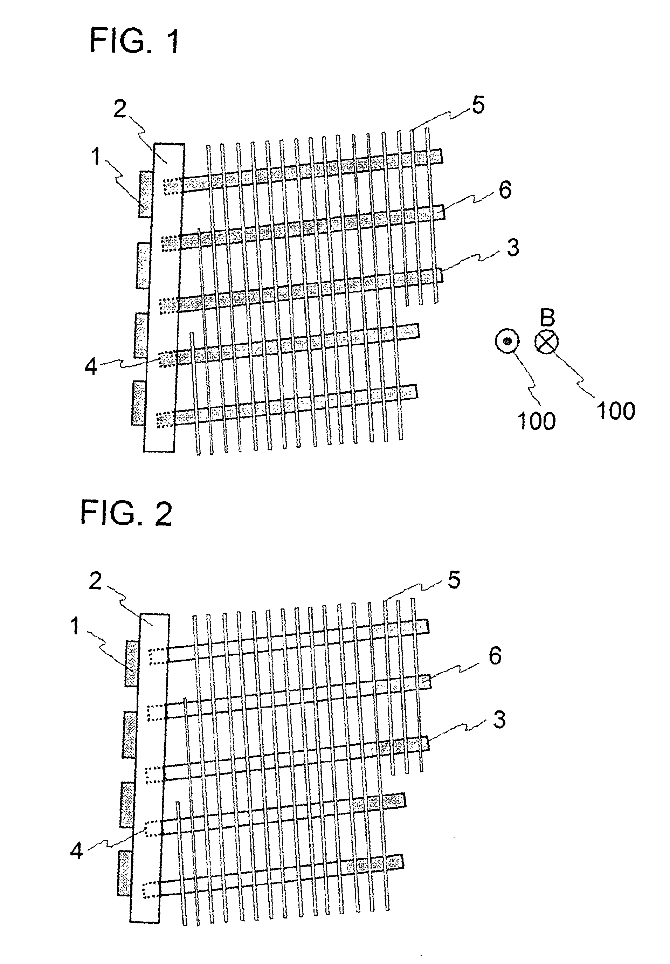

A heat pipe cooler is illustrated in Fig. 1. A heat pipe cooler is arranged so that a heat receiving section 4 of the heat pipe is in thermal contact with a semiconductor device for the power conversion 1 via a heat-receiving member 2, wherein a refrigerant 6 is filled in the heat receiving section 4 of the heat pipe and a heat radiating section 3 of the heat pipe. Fluorine compounds such as hydrofluorocarbon are widely used as the refrigerant 6. However, from the viewpoint of environmental load, there is a tendency to restrict the use of fluorine compounds, and heat pipe coolers using deionized water as substitute refrigerant are being developed and put to practical use.

In order to cope with the problem of the refrigerant freezing in a below-zero environment when deionized water is used as the refrigerant, a method is proposed for detecting freezing of the refrigerant by measuring the temperature of a heat radiating section of a heat pipe, heat radiating fins, or a heat-receiving member of the cooler, as shown in Patent Document 2.

Patent Document 1: Japanese Patent Application Laid-Open Publication No. 2011-50166

Patent Document 2: Japanese Patent Application Laid-Open Publication No. 2008-211956

According to the method for detecting freezing of the refrigerant taught in Patent Document 2, as shown in Fig. 2, freezing is detected when the refrigerant 6 freezes near the tip of the heat radiating section 3 of the heat pipe in below-zero environment, and it is determined that freezing has occurred when the temperature of a base or fins of a cooling body falls below a predetermined value, but there are cases where the influence of the heat generated by the semiconductor devices prevents the temperature of the base or the fins of the cooling body from falling below a predetermined value, and the frozen status may not be detected or the detection of the freezing status may take much time. Since load is applied on the power converter while the cooling function is not functioning until the frozen status is detected, there are risks that excessive load may be applied on the semiconductor devices for the power conversion that may lead to failure of the devices.

In order to address the problems mentioned above, the present invention aims at providing a heat pipe cooler for cooling the semiconductor devices for the power conversion, or more precisely, for detecting freezing of the refrigerant in the heat pipe cooler.

### SUMMARY OF THE INVENTION

Accordingly, the present invention provides a power converter comprising a plurality of semiconductor devices for the power conversion, a heat-receiving member, a plurality of heat pipes, a plurality of temperature sensors, and a plurality of heat radiating fins; wherein the semiconductor devices for the power conversion are disposed on one side of the heat-receiving member; the plurality of temperature sensors are attached to a surface that is the same as the mounting surface of the semiconductor devices for the power conversion; the plurality of heat pipes are attached to another surface of the heat-receiving member; at least a portion of the plurality of heat pipes has a heat radiating section; the plurality of fins are attached to the heat radiating section of the plurality of heat pipes; and freezing of a refrigerant filled in the plurality of heat pipes can be detected by monitoring a difference between a temperature measured via the part of the plurality of temperature sensors and a temperature measured via a portion of the temperature sensors arranged at another location.

The preferred conditions of the location for arranging the plurality of temperature sensors will be described. There are two following conditions for determining the location of the temperature sensors. The first condition is a location where the surface temperature of the semiconductor devices for the power conversion becomes highest when the power converter is operated under the condition that the refrigerant within the heat pipe is not frozen, or a nearby area. The second condition is a location where the surface temperature of the semiconductor devices for the power conversion becomes highest when the power converter is operated under the condition that the refrigerant within the heat pips is frozen, or a nearby area. Temperature sensors can be arranged at two measurement points that satisfy the above conditions or more than two measurement points that satisfy the above conditions.

Further, the freezing of the refrigerant filled in the heat pipe can be detected based on a temperature difference of the temperatures measured via the temperature sensors arranged at measurement points that satisfy the above-described two conditions. The temperature difference can be caused by the thermal conduction path around the heat-receiving member and the heat receiving section of the heat pipe being changed by the freezing of the refrigerant, and changing the existence of the refrigerant in the heat receiving section of the heat pipe.

When freezing is detected, a process to control the power converter can be performed so that the inner temperature of the plurality of semiconductor devices for the power conversion is not raised excessively.

According to the present invention, the freezing of the refrigerant of the heat pipe cooler can be detected more precisely.

### BRIEF DESCRIPTION OF THE DRAWINGS

Fig. 1 is a vertical cross-sectional view of a heat pipe cooler (in the normal state);
Fig. 2 is a vertical cross-sectional view of a heat pipe cooler (when the refrigerant is frozen);
Fig. 3 shows locations for arranging a power converter and a heat pipe cooler;
Fig. 4A is a vertical cross-sectional view of a heat pipe cooler according to a preferred embodiment of the present invention;
Fig. 4B is a vertical cross-sectional view of a heat pipe cooler according to a preferred embodiment of the present invention;
Fig. 5 is a configuration circuit of a power converter according to a preferred embodiment of the present invention;
Fig. 6 illustrates a form of arrangement of semiconductor devices for the power conversion according to a preferred embodiment of the present invention;
Fig. 7A shows a state (1) to be detected by the present invention;
Fig. 7B shows a state (2) to be detected by the present invention;
Fig. 8 shows a relationship between an arrangement of the semiconductor devices for the power conversion and a direction of wind of the cooling fan according to a preferred embodiment of the present invention;
Fig. 9A shows a measurement result of a surface temperature of semiconductor devices for the power conversion according to a preferred embodiment of the present invention (when the refrigerant is not frozen);
Fig. 9B shows a measurement result of a surface temperature of semiconductor devices for the power conversion according to a preferred embodiment of the present invention (when the refrigerant is frozen);
Fig. 10 shows a location for arranging temperature sensors according to a preferred embodiment of the present invention;
Fig. 11 is a flowchart showing an operation of a power converter when freezing of the refrigerant is detected according to a preferred embodiment of the present invention;
Fig. 12 illustrates a method for installing the power converter according to another preferred embodiment of the present invention;
Fig. 13 is a vertical cross-sectional view of a heat pipe cooler according to another preferred embodiment of the present invention;
Fig. 14 shows the arrangement of semiconductor devices for the power conversion and temperature sensors according to another preferred embodiment of the present invention (when the vehicle is traveling);
Fig. 15 shows the arrangement of semiconductor devices for the power conversion and temperature sensors according to another preferred embodiment of the present invention (when the vehicle is stopped); and
Fig. 16 is an operation flowchart of a case where freezing has been detected according to another embodiment of the present invention.

### DETAILED DESCRIPTION OF THE PREFERRED EMBODIMENTS

The preferred embodiments of the present invention will now be described with reference to the drawings.

### [Embodiment 1]

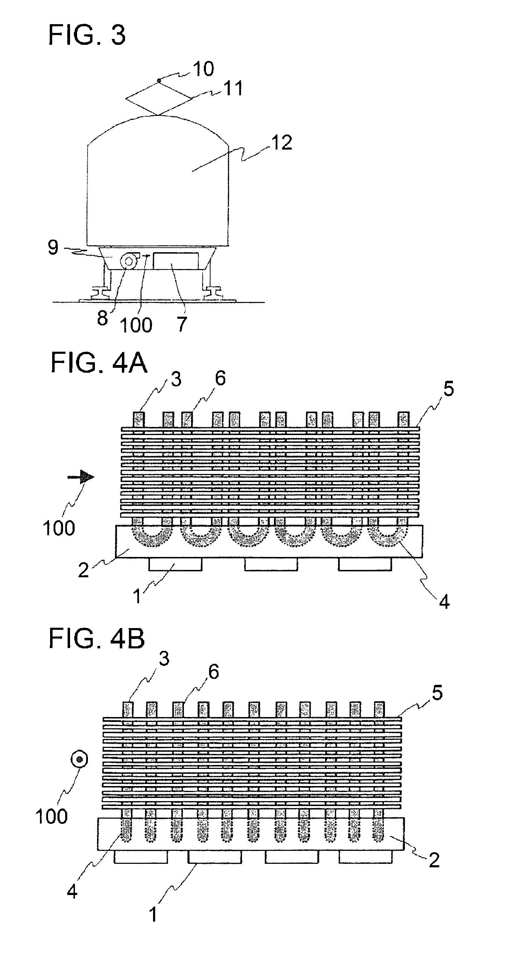

As illustrated in Fig. 3, a power converter and a heat pipe cooler according to the present invention are disposed under the floor of a railway vehicle 12 or the like, for controlling the electric power and frequency of the power supplied to a motor (not shown) for driving the vehicle, to thereby control the rotation speed of the motor. A heat pipe cooler 7 adopts an arrangement where the cooler is built into a power converter 9, and according to the example of Fig. 3, the power converter 9 is fixed so as to be suspended from the vehicle 12. A cooling fan 8 is disposed near the heat pipe cooler 7, and air is blown forcibly so as to cool semiconductor devices for the power conversion.

Figs. 4A and 4B are vertical cross-sectional views of a heat pipe cooler according to the present embodiment. In Figs. 4A and 4B, semiconductor devices for the power conversion 1 are attached to one side of a heat-receiving member 2 composed for example of aluminum alloy, and a temperature sensor (not shown) is arranged either on the surface of the semiconductor devices for the power conversion 1 or on a surface of the heat-receiving member which is the same surface as the mounting surface of the semiconductor devices for the power conversion 1. A U-shaped heat receiving section 4 of the heat pipe is embedded to the other side of the heat-receiving member 2, which is thermally in contact thereto via soldering and the like. A heat radiating section 3 of the heat pipe rises up from the heat receiving section 4 of the heat pipe, and heat radiating fins 5 are attached to the heat radiating section 3 of the heat pipe. A refrigerant 6 is filled in the heat receiving section 4 of heat pipe and the heat radiating section 3 of heat pipe. Heat is radiated through the heat radiating fins 5 to the air by blowing air in the direction of wind 100.

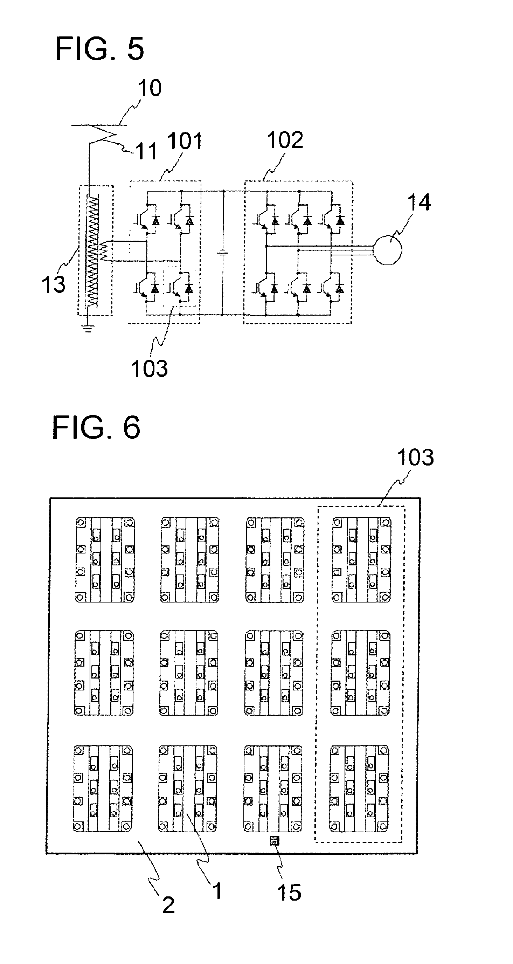

Fig. 5 illustrates a configuration circuit of a power converter according to the present embodiment. The power converter is composed of a converter unit 101 and an inverter unit 102, and performs drive control of the motor 14 connected to the inverter unit 102. AC voltage is collected from an overhead contact line 10 via a pantograph 11, and sent via a transformer 13 to the converter unit 101 of the power converter. The converter unit 101 converts the AC voltage to DC voltage, and sends the same to the inverter unit 102. The inverter unit 102 converts the DC voltage to AC voltage, and performs drive control of the motor 14. We will describe a heat pipe cooler having attached thereto a power converting semiconductor element 103 for a converter unit.

Fig. 6 illustrates an arrangement of the semiconductor devices for the power conversion. The power converting semiconductor element 103 for a converter unit illustrated in Fig. 5 is formed by arranging three power converging semiconductor devices in parallel. A temperature sensor 15 is arranged near a semiconductor device for the power conversion 1. These semiconductor devices for the power conversion and the temperature sensor are fixed to the heat-receiving member via screws or the like (not shown).

Next, we will describe the operation for cooling the semiconductor device for the power conversion with reference to Figs. 4A and 4B. The heat generated by the operation of the semiconductor devices for the power conversion 1 is conducted to the heat receiving section 4 of the heat pipe. Deionized water as fluid is filled in the heat receiving section 4 and the heat radiating section 3 of the heat pipe as the refrigerant 6. The refrigerant 6 heated by the heat of the semiconductor devices for the power conversion 1 is evaporated into gas and reaches the heat radiating section 3 of the heat pipe. The refrigerant 6 cooled via the heat radiating section 3 of the heat pipe is condensed and returns to fluid, and flows backs to the heat receiving section 4 of heat pipe by gravity. As described, cooling is performed by the repeated evaporation and condensation of the refrigerant 6.

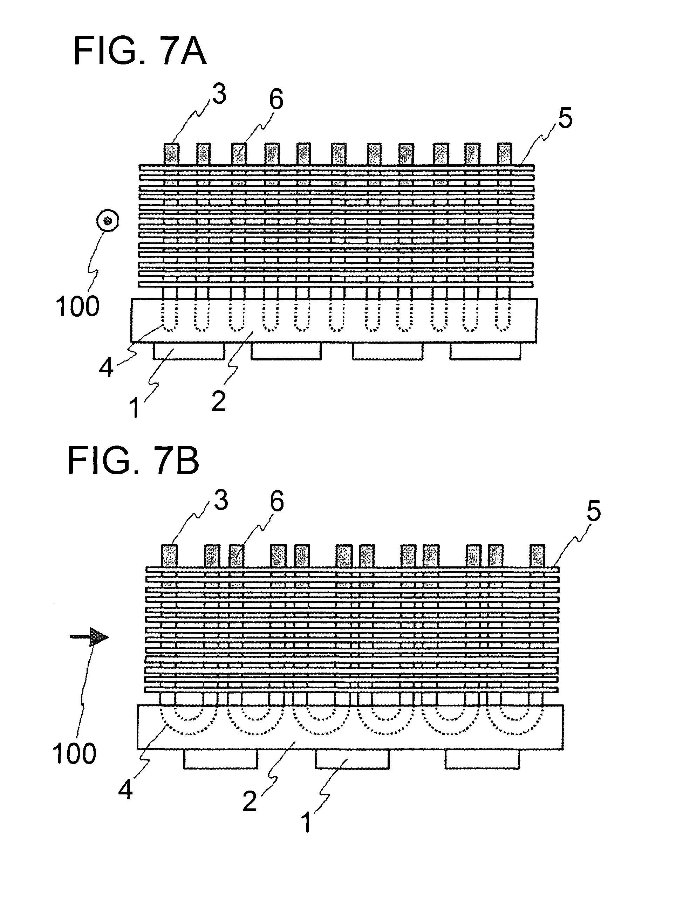

Next, we will illustrate the state to be detected by the present invention with reference to Figs. 7A and 7B. In an environment where the outer temperature is below zero, during the process for cooling the semiconductor devices for the power conversion 1, the refrigerant 6 having been condensed in the heat radiating section 3 of the heat pipe and returned to fluid will freeze and become solid. The solid refrigerant 6 will stick to the inner surface of the hat pipe heat radiating section 3 and will not be separated therefrom. Thus, the refrigerant 6 will not return to the heat receiving section 4 of the heat pipe, according to which the thermal resistance of the heat receiving section 4 will rise, and the cooling efficiency will be extremely deteriorated. A method for detecting a status where the refrigerant 6 is frozen at the tip of the heat radiating section 3 of the heat pipe illustrated in Figs. 7A and 7B will be described according to the present embodiment.

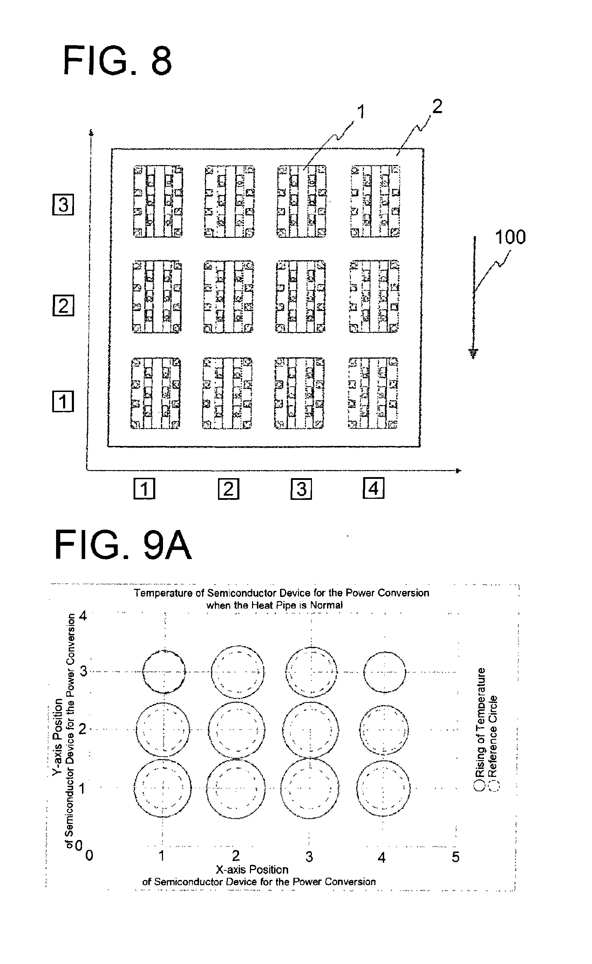

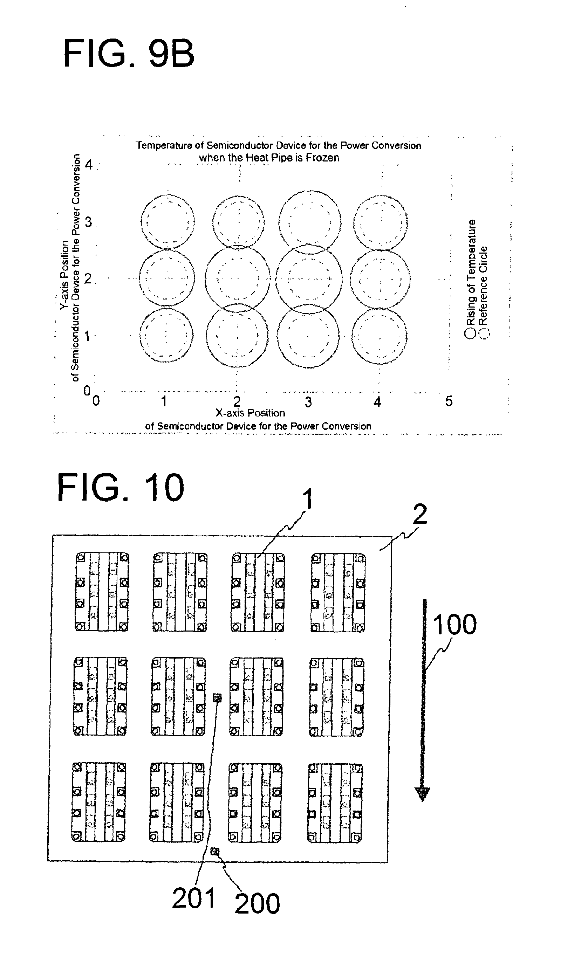

According to the arrangement of the present embodiment, the rising of temperature of the surface of the semiconductor devices for the power conversion is measured and compared between the state where the refrigerant is fluid and the state where the refrigerant is solid. The relationship between the arrangement of the semiconductor devices for the power conversion and the direction of wind by the cooling fan will be illustrated in Fig. 8. Further, Fig. 9A illustrates a temperature distribution of the respective semiconductor devices for the power conversion in the state where the refrigerant is fluid (normal state), and Fig. 9B illustrates the state where the refrigerant is solid (when the refrigerant is at a frozen state). Figs. 9A and 9B represent the values of temperature rise of the semiconductor devices for the power conversion by the size of the circles. Figs. 9A and 9B has standardized the minimum temperature rise value as 1, and the position of each circle corresponds to the arrangement of the semiconductor devices for the power conversion shown in Fig. 8. That is, cooling wind flows from the upper direction toward the lower direction of Figs. 9A and 9B. Hereafter, the positional arrangement of the semiconductor devices for the power conversion is represented by (X axis coordinate, Y axis coordinate). By comparing Figs. 9A and 9B, there are differences in the tendencies of temperature distribution between the state where the refrigerant is in a fluid state and where the refrigerant is in a solid state. When the refrigerant is in a fluid state, the surface of the semiconductor device for the power conversion arranged downwind has the highest temperature, whereas when the refrigerant is frozen, the surface of the semiconductor device for the power conversion disposed at the center has the highest temperature. In Fig. 9A, since the refrigerant exists within the heat receiving section of the heat pipe, heat radiation via the heat radiating unit of the heat pipe and the heat radiating fins is dominant. Therefore, the influence of temperature rise via cool wind becomes relatively high, so that in the upwind area, the temperature rise of the surface of the semiconductor device for the power conversion is smallest, and as the area moves downwind, the temperature rise of the surface of the semiconductor device for the power conversion becomes higher. On the other hand, since no refrigerant exists within the heat receiving section of the heat pipe in Fig. 9B, the heat conducting efficiency to the heat radiating fins is deteriorated, so that the radiation of heat from the heat-receiving member, the heat pipe heat radiating section closest to the heat-receiving member and the heat radiating fins becomes dominant, and the influence of the cooling wind becomes relatively small. As a result, the semiconductor devices for the power conversion surrounded by the semiconductor devices for the power conversion, that is, the semiconductor devices for the power conversion having (2, 2) and (3, 2) as the coordinate (X, Y) of Fig. 9B, will have higher temperature rise values. From the above reasons, the distribution of temperature rise of the semiconductor devices for the power conversion will differ between the state where the refrigerant is fluid and when the refrigerant is solid. Therefore, the temperature sensors are arranged (1) on the downwind side of the cooling air, and (2) at a center area surrounded by the semiconductor devices for the power conversion, and the relationship of temperatures is measured so as to simultaneously monitor the temperatures of the semiconductor devices for the power conversion and monitor the freezing of the refrigerant filled in the heat pipes, and further, to take necessary protecting operations before excessive load is applied on the semiconductor devices for the power conversion .

The location of the temperature sensors according to the present embodiment will be illustrated in Fig. 10. As described previously, temperature sensor A200 is disposed on the downwind side of the cooler, and temperature sensor B201 is disposed at the center area surrounded by semiconductor devices for the power conversion. The temperature sensor A200 and the temperature sensor B201 are secured to the element mounting surface. Further, the temperature measured via the temperature sensor A200 is set to TA, and the temperature measured via the temperature sensor B201 is set to TB.

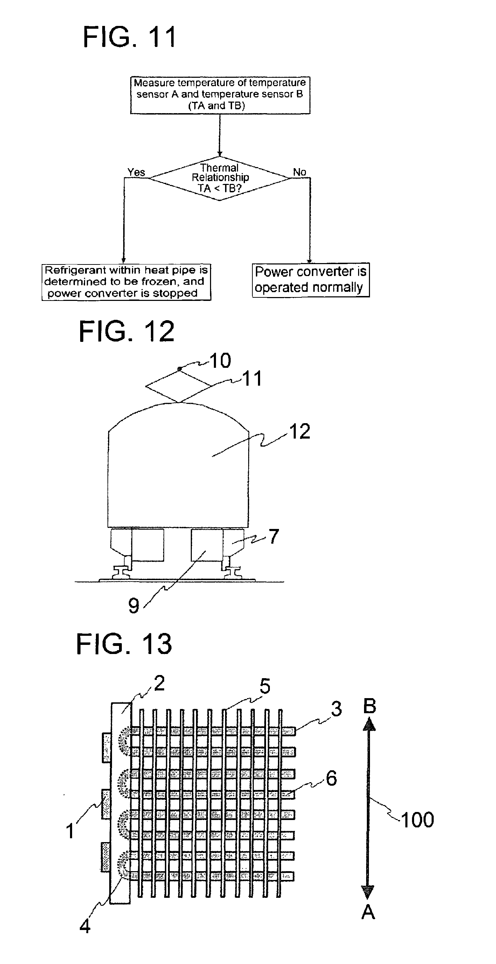

Fig. 11 illustrates an operation flowchart of the power converter when the freezing of the refrigerant has been detected according to the present embodiment. At first, temperatures TA and TB of the temperature sensors A and B are measured. Next, the magnitude relationship of TA and TB is determined. If TB is greater than TA, it is determined that the refrigerant in the heat pipe is frozen, and the power converter is stopped. If TB is smaller than TA, it is determined that the refrigerant in the heat pipe is not frozen, and the power converter is operated normally. However, the relationship between temperatures used as the basis of detecting and determining whether the refrigerant is frozen or not is not restricted to that shown in the flowchart, and other relationships can be adopted, such as "when the absolute value of the difference between TA and TB exceeds a threshold value". According to the present embodiment, when the freezing of the refrigerant has been detected by the above method, a process is performed to stop the operation of the power converter, so as to suppress the load applied on the semiconductor devices for the power conversion. However, the operation of the power converter during detection is not restricted to the above method, and other operations can be performed, such as "lowering the DC voltage being converted" or "reducing the current flown to the motor", so as to reduce the output.

It is difficult to detect the frozen state accurately if the state is determined using a threshold based on a detection result from a single temperature sensor, since the result is influenced by outer temperature and heat radiating elements, but as described according to the present invention, temperature sensors are arranged on the downwind side of the cooling wind and at a center area surrounded by semiconductor devices for the power conversion, and freezing is determined by comparing those temperatures, so that the determination can be performed based on the relative relationship of two temperature measurement results, it becomes possible to eliminate the influence of outer temperature and heat radiating elements, and the frozen state can be detected accurately and speedily.

According to the present embodiment, an example has been illustrated where temperature sensors are arranged at a center area and at a downwind area, but other locations for arranging the multiple temperature sensors can be selected as long as the following two conditions are satisfied. The first condition is a location where the surface temperature of the semiconductor device for the power conversion becomes highest when the power converter is operated under the condition that the refrigerant in the heat pipe is not frozen, or a nearby area. The second condition is a location where the surface temperature of the semiconductor device for the power conversion becomes highest when the power converter is operated under the condition that the refrigerant within the heat pipe is frozen, or a nearby area. The temperature sensor is arranged at two or more measurement points that satisfy the above conditions.

As described, according to the present embodiment, it becomes possible to monitor the temperature of the semiconductor device for the power conversion, detect the freezing of the refrigerant filled in the heat pipe, and to have the power converter carry out an operation to prevent failure of the semiconductor devices for the power conversion. The present embodiment is not only applicable to the converter unit 101 illustrated in Fig. 5, but is also applicable to the inverter unit 102. Further, the present embodiment is not only applicable to devices having the circuit configuration illustrated in Fig. 5, but is also applicable to a power converter having the above configuration where semiconductor devices for the power conversion that generate heat are arranged in parallel, and where the configuration includes an upwind and downwind relationship of the air generated from a fan.

### [Embodiment 2]

As a second embodiment of the present invention, a preferred embodiment of a power converter having a structure to take in air when a vehicle is traveling will be described with reference to the drawings. The method for installing a power converter according to the present embodiment will be shown in Fig. 12. A power converter 9 is disposed under the floor of a vehicle, for example, and adopts a configuration in which a cooler 7 is protruded from the power converter 9 for cooling semiconductor devices for the power conversion. The cooler 7 adopts a structure to take in air from a surface perpendicular to the direction of travel when the vehicle is travelling.

Figs. 1 and 13 illustrate a vertical cross-sectional view of a heat pipe cooler according to the present embodiment. A semiconductor device for the power conversion 1 is disposed on one side of a heat-receiving member 2 formed of aluminum alloy or the like. Further, U-shaped heat pipe heat receiving sections 4 are embedded to the other side surface of the heat-receiving member 2 so as to be in thermal contact therewith. However, the heat receiving section 4 of the heat pipe does not necessarily have to be U-shaped. A heat radiating section 3 of the heat pipe rises up from the heat receiving section 4 of the heat pipe, and multiple heat radiating fins 5 are attached to the heat radiating section 3 of the heat pipe. A refrigerant 6 is filled in the heat receiving section 4 and the heat radiating section 3 of the heat pipe. The direction for taking in air differs based on whether the vehicle is traveling forward or backward, so that there are two directions considered as the direction of wind 100. When the vehicle is traveling forward, the direction of wind 100 is direction A, and when the vehicle is traveling backward, the direction of wind 100 is direction B. In the present embodiment, the cooling process by the heat pipe cooler is similar to the first embodiment.

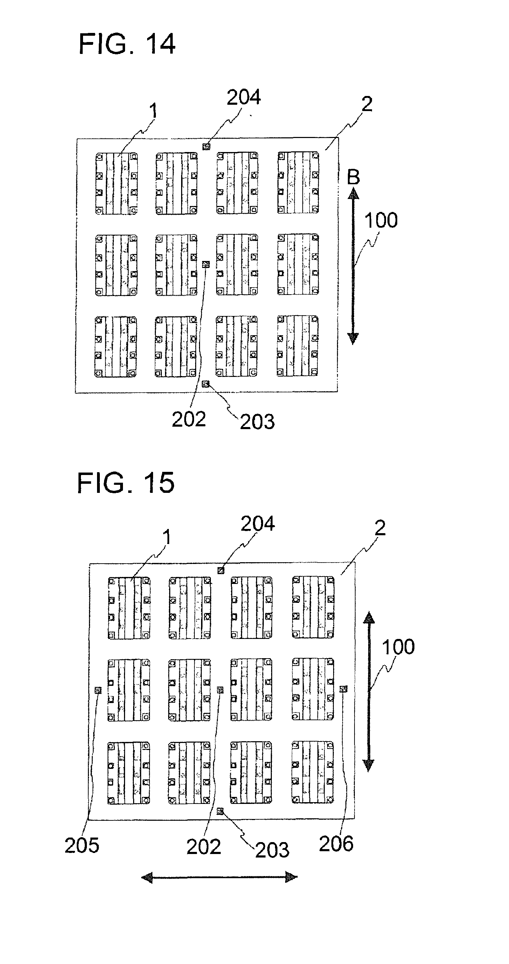

Fig. 14 shows the locations of semiconductor devices for the power conversion and temperature sensing elements according to the present embodiment. The configuration circuit of the power converter and the area for applying the heat pipe cooler are the same as the first embodiment. Based on the temperature distribution acquired by the first embodiment, if the vehicle is traveling forward, freezing can be detected by comparing the temperature measured via a temperature sensor C202 disposed at the center and the temperature measured via a temperature sensor D203 arranged on the downwind side. Further, if the vehicle is traveling backward, freezing can be detected by comparing the temperature measured via a temperature sensor C202 disposed at the center and the temperature measured via a temperature sensor E204 arranged on the downwind side. It is possible to detect freezing based on the differences in temperature distribution by monitoring the thermal relationship between the temperature sensor D203 and the temperature sensor E204, regardless of whether the vehicle is traveling forward or backward, but the temperature sensor C202 has been introduced so as to measure in parallel the temperature of the semiconductor device for the power conversion that has the highest temperature when the refrigerant is frozen. Therefore, in a system where air is taken in by the traveling of the vehicle to cool the semiconductor devices for the power conversion, the freezing can be detected regardless of whether the vehicle is traveling forward or backward, by placing temperature sensors to three measurement points of temperature sensor C202, temperature sensor D203, and temperature sensor E204. Further, the temperature measured via the temperature sensor C202 is referred to as TC, the temperature measured via the temperature sensor D203 is referred to as TD, and the temperature measured via the temperature sensor E204 is referred to as TE.

In the second embodiment of the present invention, the arrangement of semiconductor devices for the power conversion and temperature sensors considering the case where the vehicle is stopped will be illustrated in Fig. 15. When the vehicle is stopped, it is necessary to consider taking in wind randomly from the direction of travel of the vehicle and the direction perpendicular to the ground (direction of arrow). Therefore, in addition to the temperature sensors illustrated in Fig. 14, a temperature sensor F205 and a temperature sensor G206 are additionally arranged on the downwind side of natural convection. Freezing can be detected by comparing the respective temperatures measured by the temperature sensor C202 with the temperatures measured by the temperature sensor D203, the temperature sensor E204, the temperature sensor F205 and the temperature sensor G206. The temperature measured via the temperature sensor F205 is referred to as TF, and the temperature measured via the temperature sensor G206 is referred to as TG.

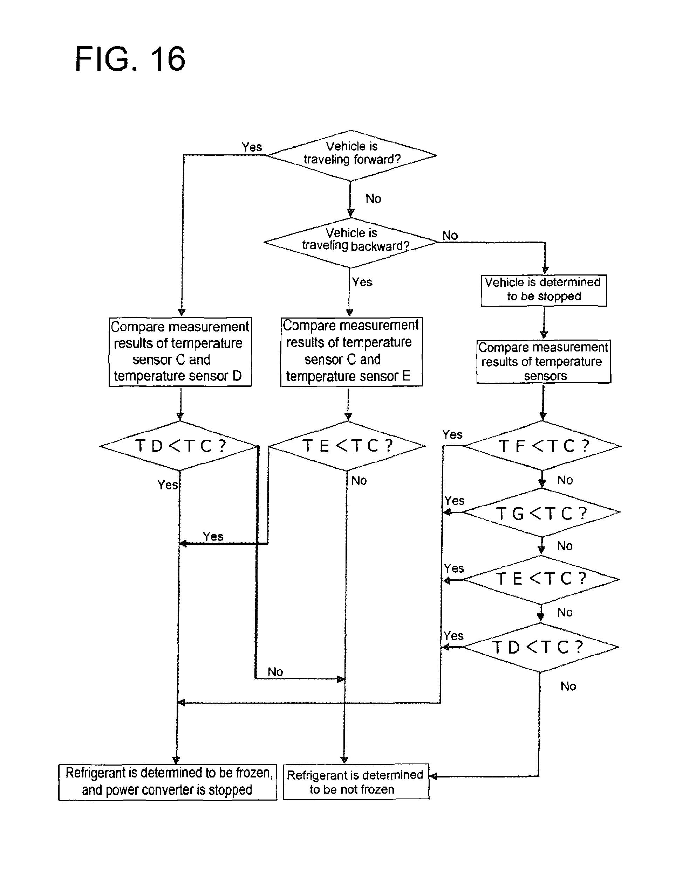

The operation flowchart when freezing has been detected according to embodiment 2 will be shown in Fig. 16. At first, according to the present embodiment, when the vehicle is traveling forward, the measurement results of the temperature sensor C and the temperature sensor D are compared, and if TD < TC, it is determined that the refrigerant is frozen. When the vehicle is moving backward, the measurement results of the temperature sensor C and the temperature sensor E are compared, and if TE < TC, it is determined that the refrigerant is frozen. Next, when the vehicle is stopped, the measurement results of the temperature sensor C and the respective temperature sensors are compared, and if any one of TF, TG, TE or TD is smaller than TC, it is determined that the refrigerant is frozen.

According to the present embodiment, when freezing of the refrigerant has been detected by the method illustrated in Fig. 16, the operation of the power converter is stopped so as to suppress the load applied on the semiconductor device for the power conversion. However, the method for detecting freezing of the refrigerant is not restricted to the method illustrated in Fig. 16, and freezing can be detected "when any one of the absolute values of differences between TC and TD, TE, TF, TG, respectively, exceed a threshold value". Furthermore, the operation of the power converter during detection is not restricted to the above method, and can be other operations such as "lowering the DC voltage being converted", or "reducing the current flown to the motor".

According to the flowchart illustrated in Fig. 16, an example has been illustrated so that when the vehicle is stopped, the temperature sensor C is compared with the respective temperature sensors, but when the vehicle is stopped, since wind is flown vertically from the lower side toward the upper direction via natural convection, it is possible to compare the measurement results of the temperature sensor C with the temperature sensors disposed on the upper side in the vertical direction, and to determine that the refrigerant is frozen when the measurement temperature of the temperature sensor disposed on the upper vertical side becomes smaller than the TC.

### References

- 1, 103: Semiconductor device for the power conversion
- 2: Heat-receiving member
- 3: Heat radiating section of heat pipe
- 4: Heat receiving section of heat pipe
- 5: Heat radiating fins
- 6: Refrigerant
- 7: Cooler
- 8: Cooling fan
- 9: Power converter
- 10: Overhead contact line
- 11: Pantograph
- 12: Vehicle body
- 13: Transformer
- 14: Motor
- 15: Temperature sensor
- 100: Direction of wind
- 101: Converter unit of power converter
- 102: Inverter unit of power converter
- 200: Temperature sensor A
- 201: Temperature sensor B
- 202: Temperature sensor C
- 203: Temperature sensor D
- 204: Temperature sensor E
- 205: Temperature sensor F
- 206: Temperature sensor G

## Claims

1. A power converter comprising a plurality of semiconductor devices for the power conversion, a heat-receiving member, a plurality of heat pipes, a plurality of temperature sensors, and a plurality of heat radiating fins; wherein
the semiconductor devices for the power conversion are disposed on one side of the heat-receiving member;
the temperature sensors are attached to either the surface of the semiconductor devices for the power conversion or to a heat-receiving member surface that is the same as a mounting surface of the semiconductor devices for the power conversion;
the plurality of heat pipes are attached to another surface of the heat-receiving member;
at least a portion of the plurality of heat pipes has a heat radiating section; the plurality of fins are attached to the heat radiating section of the plurality of heat pipes; and
freezing of a refrigerant filled in the plurality of heat pipes can be detected by monitoring a difference between a temperature measured via a portion of the plurality of temperature sensors and a temperature measured via a portion of the temperature sensors arranged at another location.

2. The power converter according to claim 1, the device further comprising:
a cooling fan for blowing air to the plurality of heat pipes or the plurality of heat radiating fins;
a portion of the plurality of temperature sensors is arranged at a location surrounded by the semiconductor devices for the power conversion;
a portion of the plurality of temperature sensors is arranged at a location not surrounded by the semiconductor devices for the power conversion, and at a location arranged downwind than the semiconductor devices for the power conversion with respect to the direction of air blow of the cooling fan.

3. The power converter according to claim 2, wherein
freezing of the refrigerant within the heat pipe is detected when a measurement temperature of the temperature sensor arranged at a location surrounded by the semiconductor devices for the power conversion is greater than a measurement temperature of the other temperature sensors not surrounded by the semiconductor devices for the power conversion and located downwind than the semiconductor devices for the power conversion.

4. The power converter according to claim 1, wherein
a configuration is adopted to take in air when a vehicle is traveling;
a configuration is adopted to blow the air having been taken in toward the plurality of heat pipes or the plurality of heat radiating fins;
a portion of the plurality of temperature sensors are located frontward with respect to a direction of travel of the vehicle; and
a portion of the plurality of temperature sensors are located rearward with respect to the direction of travel of the vehicle.

5. The power converter according to claim 4, wherein
a portion of the plurality of temperature sensors are disposed at a location surrounded by the semiconductor devices for the power conversion.

6. The power converter according to claim 5, wherein
freezing of the refrigerant within the heat pipe is detected when a measured temperature of the temperature sensor disposed at a location surrounded by the semiconductor devices for the power conversion is greater than a measured temperature of the other temperature sensor arranged rearward than the semiconductor devices for the power conversion in the direction of travel of the vehicle.

7. The power converter according to any one of claims 1 to 6, wherein
a power converting operation is stopped when the freezing of the refrigerant is detected.

8. The power converter according to any one of claims 1 to 6, wherein
an operation for reducing output is performed when the freezing of the refrigerant is detected.

9. A method for detecting freezing of a refrigerant of a power converter having refrigerant filled in at least a portion of the plurality of heat pipes, the power converter comprising:
a plurality of semiconductor devices for the power conversion, a heat-receiving member, a plurality of heat pipes, a plurality of temperature sensors, and a plurality of heat radiating fins; wherein
the semiconductor devices for the power conversion are disposed on one side of the heat-receiving member;
the temperature sensors are attached to either the surface of the semiconductor devices for the power conversion or to a heat-receiving member surface that is the same as a mounting surface of the semiconductor devices for the power conversion;
the plurality of heat pipes are attached to another surface of the heat-receiving member;
at least a portion of the plurality of heat pipes has a heat radiating section; and
the plurality of fins are attached to the heat radiating section of the plurality of heat pipes; wherein
freezing of the refrigerant filled in the plurality of heat pipes can be detected by monitoring a difference between a temperature measured via a portion of the plurality of temperature sensors and a temperature measured via a portion of the temperature sensors arranged at another location.
